(19) Europäisches Patentamt
European Patent Office
Office européen des brevets

(11) **EP 4 651 163 A1**

(12) **EUROPEAN PATENT APPLICATION**

(43) Date of publication:
**19.11.2025 Bulletin 2025/47**

(21) Application number: **25174760.6**

(22) Date of filing: **07.05.2025**

(51) International Patent Classification (IPC):
*H01F 27/38* (2006.01)     *H01F 3/10* (2006.01)
*H01F 3/14* (2006.01)     *H02M 1/00* (2006.01)

(52) Cooperative Patent Classification (CPC):
**H01F 27/38; H01F 3/10; H01F 3/14; H02M 3/015**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **08.05.2024 CN 202410567876**

(71) Applicant: **Anker Innovations Technology Co.,
Ltd.
Changsha, Hunan 410000 (CN)**

(72) Inventor: **ZHU, Yuan
Shenzhen (CN)**

(74) Representative: **Steffens, Adrian
Boehmert & Boehmert
Anwaltspartnerschaft mbB
Pettenkoferstraße 22
80336 München (DE)**

(54) **MAGNETIC DEVICE AND METHOD FOR APPLYING SAME**

(57)     Disclosed are a magnetic device and a method for applying a magnetic device. The magnetic device includes: a first magnetic element (101); a second magnetic element (102); a third magnetic element (103); a fourth magnetic element (104) magnetically connected with one end of the first magnetic element (101), one end of the second magnetic element (102) and one end of the third magnetic element (103) separately; a fifth magnetic element (105) magnetically connected with the other end of the first magnetic element (101), the other end of the second magnetic element (102) and the other end of the third magnetic element (103) separately; a primary coil (106), one part (1061) of which is wound around the second magnetic element (102), and the other part (1062) of which is wound around the third magnetic element (103), wherein an end of the one part (1061) of the primary coil (106) and an end of the other part (1062) of the primary coil (106) which are separately close to the fourth magnetic element (104) are homonymous ends to each other, or an end of the one part (1061) of the primary coil (106) and an end of the other part (1062) of the primary coil (106) which are separately close to the fifth magnetic element (105) are homonymous ends to each other; a secondary coil (107) wound around the second magnetic element (102); and a mutual inductance coil (108) wound around the third magnetic element (103). The above mode can reduce a volume of the magnetic device with transforming, resonance and mutual inductance capabilities.

FIG. 1

EP 4 651 163 A1

## Description

Field

The present disclosure relates to the technical field of magnetism, in particular to a magnetic device and a method for applying the magnetic device.

Background

In the related art, there are generally three devices in a resonant circuit with a high utilization rate: a transformer, a resonant inductor and a mutual inductor. In practice, it is usually necessary to provide the three devices of a transformer, a resonant inductor and a mutual inductor at the same time when using the resonant circuit, so as to enable the resonant circuit to operate normally.

A defect of the related art is that it is usually necessary to provide the transformer, the resonant inductor and the mutual inductor in the resonant circuit at the same time and a total volume of the transformer, the resonant inductor and the mutual inductor is large, which easily results in a large volume of a magnetic device including the transformer, the resonant inductor and the mutual inductor used in the resonant circuit.

Summary

A technical problem mainly solved by the disclosure is how to reduce a volume of a magnetic device with transforming, resonance and mutual inductance capabilities.

In order to solve the above technical problem, a magnetic device and a method are provided according to the independent claims. Further embodiments are the subject matter of the dependent claims.

According to an aspect, a magnetic device includes a first magnetic element; a second magnetic element; a third magnetic element; a fourth magnetic element magnetically connected with one end of the first magnetic element, one end of the second magnetic element and one end of the third magnetic element separately; a fifth magnetic element magnetically connected with the other end of the first magnetic element, the other end of the second magnetic element and the other end of the third magnetic element separately; a primary coil, one part of which is wound around the second magnetic element, and the other part of which is wound around the third magnetic element, wherein an end of the one part of the primary coil and an end of the other part of the primary coil which are separately close to the fourth magnetic element are homonymous ends to each other, or an end of the one part of the primary coil and an end of the other part of the primary coil which are separately close to the fifth magnetic element are homonymous ends to each other; a secondary coil wound around the second magnetic element; and a mutual inductance coil wound around the third magnetic element.

In an embodiment, the number of turns of the other part of the primary coil is smaller than the number of turns of the mutual inductance coil.

In an embodiment, leakage inductance between the one part of the primary coil and the other part of the primary coil is used as a resonant inductor, and two ends of the primary coil are used as two ends of the resonant inductor; and/or two ends of the secondary coil are configured to output a secondary voltage, and/or two ends of the mutual inductance coil are configured to output a sampling current.

In an embodiment, the fifth magnetic element is magnetically connected to the other end of the first magnetic element through a first air gap, and/or the fifth magnetic element is magnetically connected to the other end of the second magnetic element through a second air gap, and/or the fifth magnetic element is magnetically connected to the other end of the third magnetic element through a third air gap.

According to another aspect, a method for applying a magnetic device which is the above magnetic device, includes:

- adjusting magnetic capability of the magnetic device based on at least one of magnetic resistance of the first air gap, magnetic resistance of the second air gap and magnetic resistance of the third air gap.

In an embodiment, said adjusting magnetic capability of the magnetic device based on at least one of the magnetic resistance of the first air gap, the magnetic resistance of the second air gap and the magnetic resistance of the third air gap includes:

- determining or adjusting an inductance value of the resonant inductor based on the magnetic resistance of the first air gap and the number of turns of the one part of the primary coil.

In an embodiment, the inductance value of the resonant inductor is determined or adjusted based on a squared value of the number of turns of the one part of the primary coil and/or a reciprocal of the magnetic resistance of the first air gap, in particular, based on a quotient of the squared value of the number of turns of the one part of the primary coil and the magnetic resistance of the first air gap.

In an embodiment, the magnetic resistance of the first air gap, the number of turns of the one part of the primary coil, and the inductance value of the resonant inductor satisfy a first formula which is:

$$L1 = (Np1)^2/R1,$$

- where L1 is the inductance value of the resonant inductor, Np1 is the number of turns of the one part of the primary coil, and R1 is the magnetic resistance of the first air gap.

In an embodiment, a reciprocal of the inductance value of excitation inductance of the primary coil is determined or adjusted based on a reciprocal inductance value of excitation inductance of the one part of the primary coil and a reciprocal inductance value of excitation inductance of the other part of the primary coil. The reciprocal inductance value of excitation inductance of the one part of the primary coil may be determined based on the number of turns of the one part of the primary coil and the magnetic resistance of the second air gap. The a reciprocal inductance value of excitation inductance of the other part of the primary coil may be determined based on number of turns of the one part of the primary coil and the the magnetic resistance of the third air gap.

In an embodiment, said adjusting the magnetic capability of the magnetic device based on at least one of the magnetic resistance of the first air gap, the magnetic resistance of the second air gap and the magnetic resistance of the third air gap includes:

- determining or adjusting an inductance value of excitation inductance of the primary coil based on the magnetic resistance of the second air gap, the magnetic resistance of the third air gap, and the number of turns of the one part of the primary coil.

In an embodiment, the magnetic resistance of the second air gap, the magnetic resistance of the third air gap, the number of turns of the one part of the primary coil and the excitation inductance of the primary coil satisfy a second formula which is:

$$L2=(Np1)^2/R2$$

$$L3=(Np1)^2/R3$$

$$1/L=1/L2+1/L3,$$

- where L is the inductance value of the excitation inductance of the primary coil, L2 is an inductance value of excitation inductance of the one part of the primary coil, L3 is an inductance value of excitation inductance of the other part of the primary coil, Np1 is the number of turns of the one part of the primary coil, R2 is the magnetic resistance of the second air gap, and R3 is the magnetic resistance of the third air gap.

In an embodiment, the method further includes: determining a current value of a current output by the primary coil based on the number of turns of the one part of the primary coil, the number of turns of the mutual inductance coil and a current value of a current output by the mutual inductance coil. Preferably, the number of turns of the one part of the primary coil, the number of turns of the mutual inductance coil, the current value of the current output by the mutual inductance coil and the current value of the current output by the primary coil satisfy a third formula which is:

$$Ic=(Np1/Nc)*I1,$$

- where I1 is the current value of the current output by the primary coil, Ic is the current value of the current output by the mutual inductance coil, Np1 is the number of turns of the one part of the primary coil, and Nc is the number of turns of the mutual inductance coil.

In an example, a magnetic device comprises at least one of: a first magnetic element; a second magnetic element; a third magnetic element; a fourth magnetic element magnetically connected with one end of the first magnetic element, one end of the second magnetic element and one end of the third magnetic element separately; a fifth magnetic element magnetically connected with the other end of the first magnetic element, the other end of the second magnetic element and the other end of the third magnetic element separately; a primary coil, one part of which is wound around the second magnetic element, and the other part of which is wound around the third magnetic element, wherein an end of the one part of the primary coil and an end of the other part of the primary coil which are separately close to the fourth magnetic element are homonymous ends to each other, or an end of the one part of the primary coil and an end of the other part of the primary coil which are separately close to the fifth magnetic element are homonymous ends to each other; a secondary coil wound around the second magnetic element; and a mutual inductance coil wound around the third magnetic element.

Beneficial effects of the disclosure are: different from the related art, in the technical solution of the disclosure, the fourth magnetic element is magnetically connected with one end of the first magnetic element, one end of the second magnetic element and one end of the third magnetic element separately, the fifth magnetic element is magnetically connected with the other end of the first magnetic element, the other end of the second magnetic element and the other end of the third magnetic element separately, one part of the primary coil is wound around the second magnetic element, and the other part of the primary coil is wound around the third magnetic element. An end of one part of the primary coil and an end of the other part of the primary coil which are proximate to the fourth magnetic element are homonymous ends to each other, or an end of the one part of the primary coil and an end of the other part of the primary coil which are proximate to the fifth magnetic element are homonymous ends to each other, the secondary coil is wound around the second magnetic element, and the mutual inductance coil is wound around the third magnetic element. Based on the above mode, the leakage inductance between one part of the primary coil and the other part of the primary coil can be used as the resonant inductor, and can also be used based on the transformer constructed with one part of the primary coil and the secondary coil or based on the mutual inductor constructed with the other part of the primary coil and the mutual inductance coil. By winding all of the coils related to the resonant inductor, the transformer and the mutual inductor on two magnetic cores, the resonant inductor, the transformer and the mutual inductor are integrated on a same magnetic device, thus reducing a volume of the magnetic device with transforming, resonance and mutual inductance capabilities.

Brief Description of the Drawings

In order to more clearly illustrate technical solutions in embodiments of the present disclosure, drawings that need to be used in description of the embodiments are briefly introduced below. It will be apparent in to those of ordinary skill in the art that the drawings in the following description are only some embodiments of the disclosure, and other drawings can be obtained in accordance with these drawings without inventive labor.

FIG. 1    is a schematic structural diagram of an embodiment of a magnetic device of the present disclosure;

FIG. 2    is a schematic structural diagram of an embodiment of an equivalent magnetic circuit of the magnetic device of the present disclosure; and

FIG. 3    is a schematic structural diagram of an embodiment of an equivalent electric circuit of the magnetic device of the present disclosure.

Reference numerals: First Magnetic Element 101, Second Magnetic Element 102, Third Magnetic Element 103, Fourth Magnetic Element 104, Fifth Magnetic Element 105, Primary Coil 106, One Part 1061 of Primary Coil 106, Another Part 1062 of Primary Coil 106, Secondary Coil 107, Mutual Inductance Coil 108, First Air Gap 109, Second Air Gap 110, Third Air Gap 111, First Magnetoresistor 21, Second Magnetoresistor 22, Third Magnetoresistor 23, First Magnetic Source 24, Second Magnetic Source 25, Third Magnetic Source 26, Fourth Magnetic Source 27, First inductor 31, Second Inductor 32, Third Inductor 33, Fourth Inductor 34, Fifth Inductor 35, Sixth Inductor 36, Seventh Inductor 37, Eighth Inductor 38.

Detailed Description

The present disclosure will be further described in detail below with reference to the accompanying drawings and embodiments. It is particularly pointed out that the following embodiments are only used to describe the present disclosure, but do not limit the scope of the present disclosure. Likewise, the following embodiments are merely part rather than all of embodiments of the present disclosure, and all other embodiments obtained by a person of ordinary skill in the art without inventive labor shall belong to the protection scope of the present disclosure.

Reference to "embodiment" herein means that a particular feature, structure, or characteristic described with reference to an embodiment can be included in at least one embodiment of the present disclosure. Embodiments appearing in various places in the description do not necessarily refer to the same embodiment, and are not independent or alternative embodiments mutually exclusive of other embodiments. It is understood explicitly and implicitly by a person skilled in the art that the embodiments described herein may be combined with other embodiments.

In description of the present disclosure, terms such as "mount", "provide", "communicate" and "connect" should be understood broadly unless expressly specified or defined. For example, the "connect" may refer to fixed connection, detachable connection, or integrated connection; mechanical connection or electric connection; or direct connection or connection at intervals via an intermediary. Specific meanings of the above terms in the disclosure may be understood in specific circumstances by those skilled in the art.

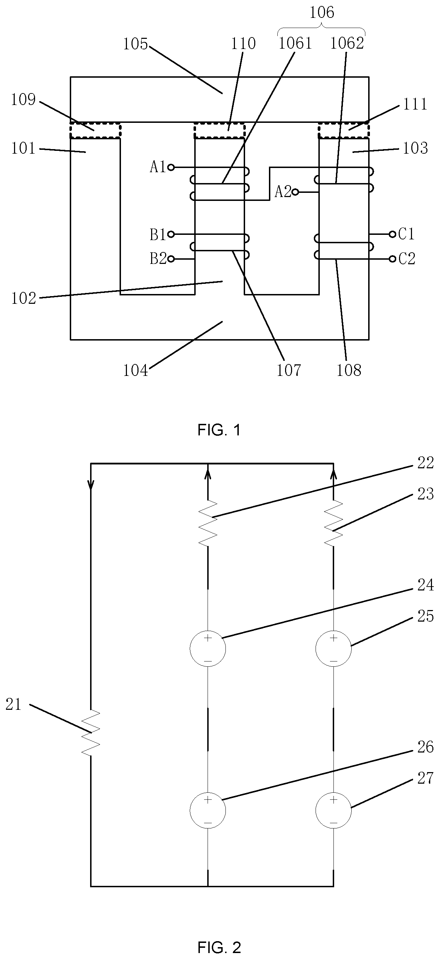

The disclosure first proposes a magnetic device, referring to FIG. 1, which is a schematic structural diagram of an embodiment of a magnetic device of the disclosure. As shown in FIG. 1, the magnetic device includes a first magnetic element 101, a second magnetic element 102, a third magnetic element 103, a fourth magnetic element 104, a fifth magnetic element 105, a primary coil 106, a secondary coil 107 and a mutual inductance coil 108.

The fourth magnetic element 104 is magnetically connected with one end of the first magnetic element 101, one end of the second magnetic element 102 and one end of the third magnetic element 103, separately. The fifth magnetic element 105 is magnetically connected with the other end of the first magnetic element 101, the other end of the second magnetic element 102 and the other end of the third magnetic element 103 separately.

The first magnetic element 101, the second magnetic element 102, the third magnetic element 103 and the fourth magnetic element 104 can be in an integral magnetic structure or magnetic structures independent of but magnetically connected with each other.

For example, when the first magnetic element 101, the second magnetic element 102, the third magnetic element 103, and the fourth magnetic element 104 are in an integral magnetic structure, the integral magnetic structure may be specifically a pot magnetic core, an RM magnetic core, an E magnetic core, a PQ magnetic core, or other types of magnetic core structures that satisfy a relative positional relationship among the first magnetic element 101, the second magnetic element 102, the third magnetic element 103 and the fourth magnetic element 104, and the magnetic core structure can be specifically selected according to actual needs, which is not limited here.

Air gaps can be respectively provided between the fifth magnetic element 105 and the first magnetic element 101, the second magnetic element 102, and the third magnetic element 103. By adjusting widths of the air gaps, magnetic resistance in magnetic connections respectively formed in the air gaps at respective positions can be adjusted. In an example, the air gap can be a spacing air column formed by air between adjacent magnetic elements.

One part 1061 of the primary coil 106 is wound around the second magnetic element 102, and the other part 1062 of the primary coil 106 is wound around the third magnetic element 103. The secondary coil 107 is wound around the second magnetic element 102. The mutual inductance coil 108 is wound around the third magnetic element 103.

An end of one part of the primary coil 106 and an end of the other part of the primary coil 106 which are separately close to the fourth magnetic element 104 are homonymous ends to each other, or an end of one part of the primary coil 106 and an end of the other part of the primary coil 106 which are separately close to the fifth magnetic element 105 are homonymous ends to each other, and in this way, a magnetic flux direction on the second magnetic element 102 can be the same as a magnetic flux direction on the third magnetic element 103, so that magnetic flux on the second magnetic element 102 and magnetic flux on the third magnetic element 103 as a whole are in magnetic flux balance with magnetic flux on the first magnetic element 101, thus forming a magnetic circuit between the first magnetic element 101 and the second magnetic element 102 and a magnetic circuit between the first magnetic element 101 and the third magnetic element 103.

The homonymous end is an important feature in a transformer, a mutual inductor and other devices, which determines a phase relationship between internal electromotive forces of the primary coil and the secondary coil. The homonymous ends usually indicate that ends with a same potential polarity in two or more windings at any time under the action of a same alternating flux are homonymous ends to each other. In the transformer, polarities of the primary and secondary windings are indicated by "·". If two corresponding ends of the primary and secondary coils are both with "·", it indicates that phases of induced electromotive forces at the two ends are the same, and the two ends are called homonymous ends. If one of the two ends is with "·" but the other of the two ends is without "·", it indicates that phases of the induced electromotive forces at the two ends are opposite to each other, and the two ends are called non-homonymous ends, also called opposite ends.

When a current is input to an end A1 of the primary coil and flows out from an end A2, corresponding change in electric field can be formed on a structural basis of the above two magnetic circuits. The end A1 and end A2 of the primary coil are opposite ends of the primary coil, the end A1 of the primary coil is located on the second magnetic element 102, and the end A2 of the primary coil is located on the third magnetic element 103.

Firstly, one part 1061 of the primary coil 106 wound around the second magnetic element 102 and the secondary coil 107 wound around the second magnetic element 102 can form a transformer, and a voltage between two ends B1 and B2 of the secondary coil 107 can be adjusted by adjusting a ratio of the number of turns of the one part 1061 of the primary coil 106 to the number of turns of the secondary coil 107 and a voltage across the one part 1061 of the primary coil 106, so that the magnetic device has transformation capability. Both the ends B1 and B2 of the secondary coil 107 are located on the second magnetic element 102 and extend in a same direction.

Secondly, leakage inductance between the one part 1061 of the primary coil 106 and the other part 1062 of the primary coil 106 which are wound around different magnetic cores can be used as a resonant inductor. Specifically, the two ends A1 and A2 of the primary coil 106 can be used as two ends of the resonant inductor and connected to a corresponding resonant circuit for use, so that the magnetic device has resonance capability.

Thirdly, the other part 1062 of the primary coil 106 wound around the third magnetic element 103 and the mutual inductance coil 108 wound around the third magnetic element 103 can form a mutual inductor, and a current in the primary coil 106 can be determined based on sampling of mutual inductance currents at two ends C1 and C2 of the secondary coil 107 to realize mutual inductance, and based on this, a magnitude of the current input to the primary coil 106 can be monitored and adjusted to ensure that the transformer or the resonant inductor can maintain normal operation. Both the two ends C1 and C2 of the secondary coil 107 are located on the third magnetic element 103 and extend in a same direction.

Different from the related art, in the technical solution of the disclosure, the fourth magnetic element is magnetically connected with one end of the first magnetic element, one end of the second magnetic element and one end of the third magnetic element separately, the fifth magnetic element is magnetically connected with the other end of the first magnetic element, the other end of the second magnetic element and the other end of the third magnetic element separately, one part of the primary coil is wound around the second magnetic element, and the other part of the primary coil is wound around the third magnetic element. An end of one part of the primary coil and an end of the other part of the primary coil which are proximate to the fourth magnetic element are homonymous ends to each other, or an end of the one part of the primary coil and an end of the other part of the primary coil which are proximate to the fifth magnetic element are homonymous ends to each other, the secondary coil is wound around the second magnetic element, and the mutual inductance coil is wound around the third magnetic element. Based on the above mode, the leakage inductance between one part of the primary coil and the other part of the primary coil can be used as the resonant inductor, and can also be used based on the transformer constructed with one part of the primary coil and the secondary coil or based on the mutual inductor constructed with the other part of the primary coil and the mutual inductance coil. By winding all of the coils related to the resonant inductor, the transformer and the mutual inductor on two magnetic cores, the resonant inductor, the transformer and the mutual inductor are integrated on a same magnetic device, thus reducing a volume of the magnetic device with transforming, resonance and mutual inductance capabilities.

In an embodiment, the number of turns of the other part 1062 of the primary coil 106 is smaller than the number of turns of the mutual inductance coil 108.

Specifically, by making the number of turns of the other part 1062 of the primary coil 106 smaller than the number of turns of the mutual inductance coil 108, the current in the mutual inductance coil 108 can be made smaller than the current in the primary coil 106, and thus the mutual inductance coil 108 can output a current obtained by reducing the current in the primary coil 106 by a corresponding coil turn ratio as a mutual inductance current. A person skilled can determine the current in the primary coil 106 according to the mutual inductance current and the ratio of the number of turns of the other part 1062 of the primary coil 106 to the number of turns of the mutual inductance coil 108, thus monitoring and adjusting the current in the primary coil 106, also reducing possibility of damage to a corresponding current sampling apparatus caused by an excessively high mutual inductance current, and improving reliability of the magnetic device.

In an embodiment, the leakage inductance between the one part 1061 of the primary coil 106 and the other part 1062 of the primary coil 106 is used as the resonant inductor, and two ends of the primary coil 106 are used as two ends of the resonant inductor. In an embodiment, two ends of the secondary coil 107 are configured to output a secondary voltage. In an embodiment, two ends of the mutual inductance coil 108 are configured to output a sampling current.

Specifically, the fifth magnetic element 105 is magnetically connected to the other end of the first magnetic element 101 through a first air gap 109, and/or the fifth magnetic element 105 is magnetically connected to the other end of the second magnetic element 102 through a second air gap 110, and/or the fifth magnetic element 105 is magnetically connected to the other end of the third magnetic element 103 through a third air gap 111.

For example, reference is made to FIG. 2, which is a schematic structural diagram of an embodiment of an equivalent magnetic circuit of the magnetic device of the present disclosure. As shown in FIG. 2, in this equivalent magnetic circuit, one end of a first magnetoresistor 21 is connected with one end of a second magnetoresistor 22 and one end of a third magnetoresistor 23 separately, the other end of the second magnetoresistor 22 is connected with a positive pole of a first magnetic source 24, a negative pole of the first magnetic source 24 is connected with a positive pole of a third magnetic source 26, and the other end of the third magnetoresistor 23 is connected with a positive pole of a second magnetic source 25. A negative pole of the second magnetic source 25 is connected with a positive pole of a fourth magnetic source 27, and the other end of the first magnetoresistor 21 is connected with a negative pole of the third magnetic source 26 and a negative pole of the fourth magnetic source 27 separately.

The first magnetoresistor 21 is a magnetoresistor formed by the first air gap 109 in the magnetic circuit, the second magnetoresistor 22 is a magnetoresistor formed by the second air gap 110 in the magnetic circuit, the third magnetoresistor 23 is a magnetoresistor formed by the third air gap 111 in the magnetic circuit, and a magnetomotive force of the first magnetic source 24 is a magnetomotive force formed by the one part 1061 of the primary coil 106 in the magnetic circuit, a magnetomotive force of the second magnetic source 25 is a magnetomotive force formed by the other part 1062 of the primary coil 106 in the magnetic circuit, a magnetomotive force of the third magnetic source 26 is a magnetomotive force formed by the secondary coil 107 in the magnetic circuit, and a magnetomotive force of the fourth magnetic source 27 is a magnetomotive force formed by the mutual inductance coil 108 in the magnetic circuit.

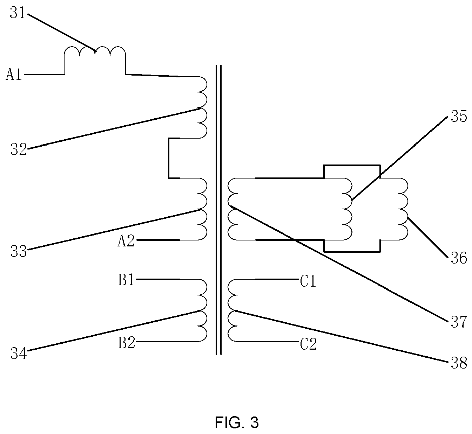

Reference is made to FIG. 3, which is a schematic structural diagram of an embodiment of the equivalent electric circuit of the magnetic device of the present disclosure. As shown in FIG. 3, a corresponding equivalent electric circuit can be obtained by performing dual conversion on the equivalent magnetic circuit. In this equivalent electric circuit, one end of a first inductor 31 is the end A1 of the primary coil, the other end of the first inductor 31 is connected with one end of a second inductor 32, the other end of the second inductor 32 is connected with one end of a third inductor 33, and the other end of the third inductor 33 is the other end A2 of the primary coil.

Two ends of a fourth inductor 34 are the two ends B1 and B2 of the secondary coil 107.

One end of a seventh inductor 37 is separately connected with one end of a fifth inductor 35 and one end of a sixth inductor 36, and the other end of the seventh inductor 37 is separately connected with the other end of the fifth inductor 35 and the other end of the sixth inductor 36.

Two ends of an eighth inductor 38 are the two ends C1 and C2 of the mutual inductance coil 108.

Inductance of the first inductor 31 can be specifically the leakage inductance between the one part 1061 and the other part 1062 of the primary coil 106, that is, inductance of the resonant inductor. The number of turns of the second inductor 32 can be the number of turns of the other part 1062 of the primary coil 106, the number of turns of the third inductor 33 and the number of turns of the seventh inductor 37 are both the number of turns of the one part 1061 of the primary coil 106, the number of turns of the fourth inductor 34 can be the number of turns of the secondary coil 107, the number of turns of the eighth inductor 38 may be the number of turns of the mutual inductance coil 108, and total inductance of the fifth inductor 35 and the sixth inductor 36 may be excitation inductance of the primary coil 106.

Based on the above equivalent electric circuit, the excitation inductance and the resonance inductance can be determined based on a primary current input and a mutual inductance current and a secondary current acquired, and then when the excitation inductance, the resonance inductance and a reduction ratio of the mutual inductance current to the primary current need to be adjusted, adaptive adjustment can be realized by adjusting the numbers of turns of the coils and the input primary current, so as to ensure normal operation of the magnetic device and meet relevant needs of a person skilled.

The disclosure further provides a method for applying a magnetic device which is the device of the embodiment in which the fifth magnetic element 105 is magnetically connected to the other end of the first magnetic element 101 through a first air gap 109, and/or the fifth magnetic element 105 is magnetically connected to the other end of the second magnetic element 102 through a second air gap 110, and/or the fifth magnetic element 105 is magnetically connected to the other end of the third magnetic element 103 through a third air gap 111.

The leakage inductance between the one part 1061 of the primary coil 106 and the other part 1062 of the primary coil 106 is used as the resonant inductor, and two ends of the primary coil 106 are used as two ends of the resonant inductor. In an embodiment, two ends of the secondary coil 107 are configured to output a secondary voltage. In an embodiment, two ends of the mutual inductance coil 108 are configured to output a sampling current.

The method for applying a magnetic device includes:

- adjusting magnetic capability of the magnetic device based on at least one of magnetic resistance of the first air gap 109, magnetic resistance of the second air gap 110 and magnetic resistance of the third air gap 111.

Specifically, for any one of the first air gap 109, the second air gap 110 and the third air gap 111, by adjusting widths of the respective air gaps, magnetic resistance of the respective air gaps can be adjusted, and relevant parameters of the equivalent magnetic circuit and the equivalent electric circuit in the magnetic device can be adjusted, thus realizing adjustment of relevant magnetic capability of the magnetic device, ensuring the normal operation of the magnetic device, and meeting relevant needs of a person skilled.

In addition, the magnetic capability of the magnetic device can be adjusted based on at least one of the number of turns of the one part 1061 of the primary coil 106, the number of turns of the other part 1062 of the primary coil 106, the number of turns of the secondary coil 107, and the number of turns of the mutual inductance coil 108, which is not limited here.

In an embodiment, said adjusting the magnetic capability of the magnetic device based on at least one of the magnetic resistance of the first air gap 109, the magnetic resistance of the second air gap 110 and the magnetic resistance of the third air gap 111 includes:

- determining or adjusting an inductance value of the resonant inductor based on the magnetic resistance of the first air gap 109 and the number of turns of the one part of the primary coil 106.

Specifically, during design of the magnetic device, the inductance value of the corresponding resonant inductor can be calculated based on the magnetic resistance of the first air gap 109 and the number of turns of the one part 1061 of the primary coil 106, so as to determine whether the designed magnetic device meets the needs. If the designed magnetic device does not meet the needs, the magnetic resistance of the first air gap 109 and the number of turns of the one part 1061 of the primary coil 106 can continue to be adjusted to influence the inductance value of the resonant inductor. If the designed magnetic device meets the needs, the adjustment can be stopped to complete the design.

In an example, the magnetic resistance of the first air gap 109, the number of turns of the one part 1061 of the primary coil 106, and the inductance value of the resonant inductor satisfy a first formula.

The first formula is:

$$L1 = (Np1)^2 / R1,$$

- where L1 is the inductance value of the resonant inductor, Np1 is the number of turns of the one part 1061 of the primary coil 106, and R1 is the magnetic resistance of the first air gap 109.

Based on the above formula, the inductance value of the resonant inductor can be determined. From the first formula, it can be known that the inductance value of the resonant inductor can be adjusted by changing at least one of the number of turns of the one part 1061 of the primary coil 106 and the magnetic resistance of the first air gap 109, so that the resonant capability of the magnetic device can meet needs of users.

In an embodiment, said adjusting the magnetic capability of the magnetic device based on at least one of the magnetic resistance of the first air gap 109, the magnetic resistance of the second air gap 110 and the magnetic resistance of the third air gap 111 includes:

- determining or adjusting an inductance value of the excitation inductance of the primary coil 106 based on the magnetic resistance of the second air gap 110, the magnetic resistance of the third air gap 111, and the number of turns of the one part 1061 of the primary coil 106.

Specifically, during design of the magnetic device, the inductance value of the excitation inductance of the primary coil 106 can be calculated based on the magnetic resistance of the second air gap 110, the magnetic resistance of the third air gap 111 and the number of turns of the one part 1061 of the primary coil 106, so as to determine whether the designed magnetic device meets the needs. If the designed magnetic device does not meet the needs, the magnetic resistance of the second air gap 110, the magnetic resistance of the third air gap 111 and the number of turns of the one part 1061 of the primary coil 106 can continue to be adjusted to influence the inductance value of the excitation inductance of the primary coil 106. If the designed magnetic device meets the needs, adjustment is stopped and the designing is completed.

In an example, the magnetic resistance of the second air gap 110, the magnetic resistance of the third air gap 111, the number of turns of the one part 1061 of the primary coil 106 and the excitation inductance of the primary coil 106 satisfy a second formula.

The second formula is:

$$L2=(Np1)^2/R2$$

$$L3=(Np1)^2/R3$$

$$1/L=1/L2+1/L3,$$

- where L is the inductance value of the excitation inductance of the primary coil 106, that is, an inductance value of the total inductance of the fifth inductor 35 and the sixth inductor 36, L2 is an inductance value of excitation inductance of the one part 1061 of the primary coil 106, L3 is an inductance value of excitation inductance of the other part 1062 of the primary coil 106, Np1 is the number of turns of the one part 1061 of the primary coil 106, and R2 is the magnetic resistance of the second air gap 110, and R3 is the magnetic resistance of the third air gap 111.

Based on the above formula, the inductance value of the excitation inductance of the primary coil 106 can be determined. From the second formula, it is known that the inductance value of the excitation inductance of the primary coil 106 can be adjusted by changing at least one of the magnetic resistance of the second air gap 110, the magnetic resistance of the third air gap 111 and the number of turns of the one part 1061 of the primary coil 106, so that the excitation inductance of the primary coil 106 of the magnetic device can meet needs of users.

In an embodiment, the method for applying the magnetic device further includes:

- determining a current value of a current output by the primary coil 106 based on the number of turns of the one part 1061 of the primary coil 106, the number of turns of the mutual inductance coil 108 and a current value of a current output by the mutual inductance coil 108.

The number of turns of the one part 1061 of the primary coil 106, the number of turns of the mutual inductance coil 108, the current value of the current output by the mutual inductance coil 108 and the current value of the current output by the primary coil 106 satisfy a third formula.

The third formula is:

$$Ic=(Np1/Nc)*I1,$$

- where I1 is the current value of the current output by the primary coil 106, Ic is the current value of the current output by the mutual inductance coil 108, Np1 is the number of turns of the one part 1061 of the primary coil 106, and Nc is the number of turns of the mutual inductance coil 108.

Based on the above formula, the current value of the current output by the primary coil 106 can be determined, or the current value of the current output by the mutual inductance coil 108 can be determined. From the third formula, it is known that a ratio of the current value of the current output by the primary coil 106 to the current value of the current output by the mutual inductance coil 108 can be adjusted by changing a ratio of the number of turns of the one part 1061 of the primary coil 106 to the number of turns of the mutual inductance coil 108, so that a reduction ratio of the mutual inductance current to the primary current can meet needs of users, that is, mutual inductance capability of the magnetic device can meet needs of users.

In description of the disclosure, description of the terms "an embodiment", "some embodiments", "an example", "a specific example", "some examples" and the like means that a specific feature, structure, material, or characteristic described in combination with the embodiment or example is included in at least one embodiment or example of the disclosure. In the description, an illustrative recitation of the above terms does not necessarily refer to the same embodiment or example. Furthermore, the specific feature, structure, material or characteristic described may be combined in any suitable manner in any one or more embodiments or examples. In addition, a person skilled in the art can incorporate and combine different embodiments or examples and features of different embodiments or examples described in the description without contradicting each other.

Moreover, the terms "first", "second", and the like are used for descriptive purposes only and are not to be construed as indicating or implying the relative importance or implicitly indicating the number of technical features indicated. Thus, features defined with "first" and "second" may explicitly or implicitly include at least one of the features. In description of the present disclosure, "a plurality of" means at least two, such as two, three or the like, unless otherwise explicitly and specifically defined herein.

The above are only preferred embodiments of the present disclosure and do not limit the scope of the disclosure. Transformation of a corresponding structure or process made with the contents of the description and drawings of the present disclosure is directly or indirectly used in other related technical fields and should be included in the protection scope of the present disclosure.

## Claims

1. A magnetic device comprising:

   - a first magnetic element (101);
   - a second magnetic element (102);
   - a third magnetic element (103);
   - a fourth magnetic element (104) magnetically connected with one end of the first magnetic element (101), one end of the second magnetic element (102) and one end of the third magnetic element (103) separately;
   - a fifth magnetic element (105) magnetically connected with the other end of the first magnetic element (101), the other end of the second magnetic element (102) and the other end of the third magnetic element (103) separately;
   - a primary coil (106), one part (1061) of which is wound around the second magnetic element (102), and the other part (1062) of which is wound around the third magnetic element (103), wherein an end of the one part (1061) of the primary coil (106) and an end of the other part (1062) of the primary coil (106) which are separately close to the fourth magnetic element (104) are homonymous ends to each other, or an end of the one part (1061) of the primary coil (106) and an end of the other part (1062) of the primary coil (106) which are separately close to the fifth magnetic element (105) are homonymous ends to each other;
   - a secondary coil (107) wound around the second magnetic element (102); and
   - a mutual inductance coil (108) wound around the third magnetic element (103).

2. The magnetic device of claim 1, wherein the number of turns of the other part (1062) of the primary coil (106) is smaller than the number of turns of the mutual inductance coil (108).

3. The magnetic device of claim 1 or 2, wherein two ends of the secondary coil (107) are configured to output a secondary voltage.

4. The magnetic device of any one of the preceding claims, wherein two ends of the mutual inductance coil (108) are configured to output a sampling current.

5. The magnetic device of any one of the preceding claims, wherein

   - leakage inductance between the one part (1061) of the primary coil (106) and the other part (1062) of the primary coil (106) is used as a resonant inductor, and two ends of the primary coil (106) are used as two ends of the resonant inductor.

6. The magnetic device of claim 5, wherein

   - the fifth magnetic element (105) is magnetically connected to the other end of the first magnetic element (101) through a first air gap (109); and/or
   - the fifth magnetic element (105) is magnetically connected to the other end of the second magnetic element (102) through a second air gap (110); and/or
   - the fifth magnetic element (105) is magnetically connected to the other end of the third magnetic element (103) through a third air gap (111).

7. A method for applying a magnetic device which is the magnetic device of claim 6, comprising:

   - adjusting a magnetic capability of the magnetic device based on at least one of magnetic resistance of the first air gap (109), magnetic resistance of the second air gap (110) and magnetic resistance of the third air gap (111).

8. The method of claim 7, wherein said adjusting magnetic capability of the magnetic device based on at least one of magnetic resistance of the first air gap (109), magnetic resistance of the second air gap (110) and magnetic resistance of the third air gap (111) comprises:

- determining or adjusting an inductance value of the resonant inductor based on the magnetic resistance of the first air gap (109) and the number of turns of the one part (1061) of the primary coil (106).

9. The method of claim 8, wherein the inductance value of the resonant inductor is determined or adjusted based on a squared value of the number of turns of the one part (1061) of the primary coil (106).

10. The method of claim 8 or 9, wherein the magnetic resistance of the first air gap (109), the number of turns of the one part (1061) of the primary coil (106) and the inductance value of the resonant inductor satisfy a first formula which is:

$$L1=(Np1)^2/R1,$$

- where L1 is the inductance value of the resonant inductor, Np1 is the number of turns of the one part (1061) of the primary coil (106), and R1 is the magnetic resistance of the first air gap (109).

11. The method of any one of claims 7 to 10, wherein said adjusting the magnetic capability of the magnetic device based on at least one of the magnetic resistance of the first air gap (109), the magnetic resistance of the second air gap (110) and the magnetic resistance of the third air gap (111) comprises:

- determining or adjusting an inductance value of excitation inductance of the primary coil (106) based on the magnetic resistance of the second air gap (110), the magnetic resistance of the third air gap (111), and the number of turns of the one part (1061) of the primary coil (106).

12. The method of claim 11, wherein a reciprocal of the inductance value of excitation inductance of the primary coil (106) is determined or adjusted based on a reciprocal inductance value of excitation inductance of the one part (1061) of the primary coil (106) and a reciprocal inductance value of excitation inductance of the other part (1062) of the primary coil (106).

13. The method of claim 11 or 12, wherein the magnetic resistance of the second air gap (110), the magnetic resistance of the third air gap (111), the number of turns of the one part (1061) of the primary coil (106)

and the excitation inductance of the primary coil (106) satisfy a second formula which is:

$$L2=(Np1)^2/R2$$

$$L3=(Np1)^2/R3$$

$$1/L=1/L2+1/L3,$$

- where L is the inductance value of the excitation inductance of the primary coil (106), L2 is an inductance value of excitation inductance of the one part (1061) of the primary coil (106), L3 is an inductance value of excitation inductance of the other part (1062) of the primary coil (106), Np1 is the number of turns of the one part (1061) of the primary coil (106), R2 is the magnetic resistance of the second air gap (110), and R3 is the magnetic resistance of the third air gap (111).

14. The method of any one of claims 7 to 13, further comprising:

- determining a current value of a current output by the primary coil (106) based on the number of turns of the one part (1061) of the primary coil (106), the number of turns of the mutual inductance coil (108) and a current value of a current output by the mutual inductance coil (108).

15. The method of claim 14, wherein:

- the number of turns of the one part (1061) of the primary coil (106), the number of turns of the mutual inductance coil (108), the current value of the current output by the mutual inductance coil (108) and the current value of the current output by the primary coil (106) satisfy a third formula which is:

$$Ic=(Np1/Nc)*I1,$$

- where I1 is the current value of the current output by the primary coil (106), Ic is the current value of the current output by the mutual inductance coil (108), Np1 is the number of turns of the one part (1061) of the primary coil (106), and Nc is the number of turns of the mutual inductance coil (108).

FIG. 1

FIG. 2

FIG. 3

Europäisches
Patentamt
European
Patent Office
Office européen
des brevets

# EUROPEAN SEARCH REPORT

**Application Number**

EP 25 17 4760

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 115 331 937 A (GUANGZHOU MORNSUN SCI & TECH) 11 November 2022 (2022-11-11) | 1-4 | INV.<br>H01F27/38 |
| A | * figures 5,6 *<br>* paragraph [0005] - paragraph [0013] *<br>* paragraphs [0059], [0064] * | 5-15 | H01F3/10<br>H01F3/14<br>H02M1/00 |
| | ----- | | |
| X | US 2019/096571 A1 (ZHANG HUAN [US] ET AL) 28 March 2019 (2019-03-28)<br>* figure 9 *<br>* paragraph [0080] - paragraph [0085] * | 1,3 | |
| | ----- | | |
| A | PERDIGAO MARINA S ET AL: "A Review on Variable Inductors and Variable Transformers: Applications to Lighting Drivers",<br>IEEE TRANSACTIONS ON INDUSTRY APPLICATIONS, IEEE SERVICE CENTER, PISCATAWAY, NJ, US,<br>vol. 52, no. 1,<br>1 January 2016 (2016-01-01), pages 531-547, XP011595713,<br>ISSN: 0093-9994, DOI: 10.1109/TIA.2015.2483580<br>[retrieved on 2016-01-18]<br>* Section D.;<br>figure T * | 1-15 | |
| | ----- | | TECHNICAL FIELDS SEARCHED (IPC)<br><br>H01F<br>H02M |

The present search report has been drawn up for all claims

| Place of search | Date of completion of the search | Examiner |
|---|---|---|
| Munich | 1 October 2025 | Tano, Valeria |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 17 4760

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-2025

| Patent document cited in search report | Publication date | Patent family member(s) | Publication date |
|---|---|---|---|
| CN 115331937 A | 11-11-2022 | NONE | |
| US 2019096571 A1 | 28-03-2019 | NONE | |

EPO FORM P0459

For more details about this annex : see Official Journal of the European Patent Office, No. 12/82